# EUROPÄISCHE PATENTSCHRIFT

(11) **EP 0 418 422 B1**
(45) Veröffentlichungstag und Bekanntmachung des Hinweises auf die Patenterteilung: **09.01.2002**
(21) Anmeldenummer: 89117580.4
(22) Anmeldetag: 22.09.1989
(51) Int. Cl.: H01L 29/732, H01L 21/331, H01L 21/8249, H01L 27/06

(54) **CMOS-kompatibler Bipolartransistor mit verringerter Kollektor/Substrat-Kapazität und Verfahren zu dessen Herstellung**
CMOS compatible bipolar transistor having a reduced collector-substrate capacitance, and method for making the same
Transistor bipolaire compatible CMOS ayant une capacité collecteur-substrat réduite et sa méthode de fabrication

(43) Veröffentlichungstag der Anmeldung: 27.03.1991
(73) Patentinhaber: Infineon Technologies AG, 81669 München (DE)
(72) Erfinder: Meister, Thomas, Dr., D-8028 Taufkirchen (DE); Klose, Helmut, Dr., D-8000 München 82 (DE); Meul, Hans Willi, Dr., D-8206 Bruckmühl (DE); Wendt, Hermann, Dr., D-8011 Neukeferloh (DE)
(74) Vertreter: Zimmermann, Gerd Heinrich

(56) Entgegenhaltungen:
- EP-A- 0 118 102
- EP-A- 0 306 213
- US-A- 4 764 801

## Beschreibung

Die Erfindung betrifft ein Verfahren zur Herstellung eines Bipolartransistors mit in vertikaler Aufeinanderfolge angeordneten Kollektor, Basis und Emitter.

Moderne Bipolartransistoren, wie sie zum Beispiel in A. W. Wieder, Siemens Forschungs- und Entwicklungsberichte, Band 13 (1984), Seiten 246 ff, beschrieben sind, weisen für den Kollektoranschluß und den aktiven Transistorbereich zwei separate Siliziuminseln auf. Diese Siliziuminseln sind durch eine hochdotierte, vergrabene Schicht, den sogenannten Subkollektor oder buried layer, miteinander verbunden. Der Subkollektor wird gewöhnlich durch Implantation in einem Substrat erzeugt. Darauf wird dann eine epitaktische Schicht für den aktiven Transistorbereich abgeschieden. Es folgt die Herstellung der Oxidisolation und die Strukturierung des Subkollektors mit einer tiefen Trenchisolation. Die Transistorgröße und die parasitäre Kollektor/Substrat-Kapazität werden in dieser Anordnung durch den großen Platzverbrauch des Subkollektors bestimmt.

Beim Entwurf von BICMOS-Schaltungen, das heißt Schaltungen, die sowohl Bipolartransistoren als auch CMOS-Transistoren enthalten und damit die Vorteile beider Technologien vereinen, hat die Herstellung der Isolation erst nach der epitaktischen Abscheidung der aktiven Transistorbereiche der Bipolartransistoren entscheidende Nachteile. Die flache Epitaxieschicht des Bipolartransistors und die Lage des Subkollektors zur Siliziumoberfläche wird nämlich auch den CMOS-Transistoren aufgezwungen. Das Geschwindigkeitspotential der Bipolartransistoren kann daher nicht ohne eine beträchtliche Degradation der Drain/Wanne-Kapazität zum Beispiel des p-Kanal-Transistors genutzt werden (siehe zum Beispiel H. Klose et al., "Well optimization for High Speed BICMOS Technologies", ESSDERC 88). Die Implementierung der für einen CMOS-prozeß unüblichen flachen Epitaxieschicht mit einer Dicke von nur etwa 1 bis 1,5 µm erfordert eine neue Einstellung der Wannenprofile.

Im Herstellverfahren für eine BICMOS-Schaltung haben die Herstellschritte für die Bipolar-Komponenten einen erheblichen Einfluß auf die CMOS-Komponenten. Es ist daher nicht möglich, ein erprobtes Bipolar-Konzept in einen BICMOS-Prozeß einzuführen, ohne einen erheblichen Entwicklungsaufwand am CMOS-Prozeß in Kauf zu nehmen.

Aus K. O. Kenneth et al, IEEE Trans. Electron. Devices, Band 36, (1989) Seiten 1362 ff ist ein Bipolartransistor bekannt, in dem die aktiven Transistorbereiche durch selektive Epitaxie auf dem Subkollektor erzeugt werden. Der Kollektoranschluß erfolgt direkt auf dem Subkollektor. Dabei sind sowohl der Basis- als auch der gesamte Kollektoranschlußbereich nicht dielektrisch vom Silizium isoliert. Dieser Bipolartransistor ist zwar für einen BICMOS-Prozeß geeignet, da seine Epitaxieschicht nicht mehr den CMOS-Transistoren aufgezwungen wird (selektive Epitaxie!). Aus der mangelnden Isolation des Basis- und Kollektoranschlußbereichs resultieren jedoch große, parasitäre Kapazitätsbeiträge, die diese Transistoren für Hochgeschwindigkeitsanwendungen ungeeignet machen. Überdies weisen diese Transistoren bei einer vorgegebenen Stromdichte eine hohe Verlustleistung und damit niedrige Werte für das Power-Delay Produkt auf.

Aus EP 0 306 213 A2 ist ein vertikaler Bipolartransistor bekannt, der einen durch epitaktisches Aufwachsen gebildeten Kollektorbereich aufweist. Der Kollektorbereich ist von einem ihn ringförmig umschließenden, an ihn seitlich angrenzenden Kollektoranschluß umgeben. Oberhalb des Kollektorbereichs ist ein Basisbereich ebenfalls in einem epitaktisch aufgewachsenen Halbleitergebiet angeordnet. An den Basisbereich grenzt seitlich von einer Seite her ein Basisanschluß an. Ein Emitterbereich ist im oberen Bereich des Basisbereichs durch Implantation gebildet. Kontakte reichen auf den Emitterbereich, den Basisanschluß und den Kollektoranschluß.

Aus US-PS 4 764 801 ist ein vertikaler Bipolartransistor bekannt, der in einem Schichtaufbau mit alternierenden Schichten aus dielektrischem Material und Halbleitermaterial gebildet ist. In den Schichtaufbau wird ein Loch geätzt, das bis auf die Oberfläche des Halbleitersubstrats reicht. Anschließend wird die Oberfläche der an das Loch angrenzenden Halbleiterschichten zum Beispiel oxidiert. Die oxidierten Oberflächen der Halbleiterschichten werden entfernt. Anschließend wird durch epitaktisches Aufwachsen das Loch und die Unterätzungen mit Halbleitermaterial aufgefüllt. Dabei wächst das Halbleitermaterial auch auf der Oberfläche der polykristallinen Halbleiterschichten auf. Die polykristallinen Halbleiterschichten bilden gleichzeitig Seitenwandkontakte für einen Kollektorbereich und einen Basisbereich.

Der Erfindung liegt daher die Aufgabe zugrunde, ein Verfahren zur Herstellung eines Bipolartransistors anzugeben, der ohne Beeinflussung der CMOS-Komponenten in einen BICMOS-Prozeß integrierbar ist und der verminderte parasitäre Kapazitäten, insbesondere eine verminderte Substrat/Kollektor-Kapazität, und eine verbesserte Kristallqualität im Kollektorbereich aufweist.

Diese Aufgabe wird erfindungsgemäß gelöst durch ein Verfahren nach Anspruch 1 oder 2.

Durch eine ringförmige Anordnung der vergrabenen Kollektoranschlußschicht um den Kollektor wird ein möglichst niederohmiger Anschluß erzielt. Als Kollektoranschlußschicht ist zum Beispiel Wolfram, Polyzid, hochdotiertes Polysilizium, Silizid odere ähnliches geeignet.

Da der Kollektoranschluß über die vergrabene Kollektoranschlußschicht erfolgt, wird für den Subkollektor eine Fläche benötigt, die nur wenig größer ist als diejenige für den aktiven Kollektor. Die Kontaktfläche zwischen dem vergrabenen Bereich und dem Substrat führt zu der Kollektor/Substrat-Kapazität. Da die vergrabene Kollektoranschlußschicht im wesentlichen auf den Isolationsoxidbereichen angeordnet ist, liefert auch sie keinen nennenswerten Beitrag zur Kollektor/Substrat-Kapazität.

Der aktive Transistorbereich wird im erfindungsgemäßen Transistor durch selektive Epitaxie erzeugt.

Der Subkollektor ist im Substrat angeordnet. Im Substrat ist der Subkollektor von den Isolationsoxidbereichen umgeben. Der Subkollektor wird dabei durch Ausdiffusion aus einer darüber angeordneten leitfähigen Schicht erzeugt. Aus der leitfähigen Schicht entsteht die vergrabene Kollektoranschlußschicht. Der Kollektor ist entweder justiert oder selbstjustiert zum Kollektoranschluß angeordnet.

Auf der Kollektoranschlußschicht wird die den Kollektor umgebende Isolationsstruktur erzeugt. Der Kollektor wird durch selektive Epitaxie innerhalb der Isolationsstruktur hergestellt.

Auf die sich ergebende Struktur wird der Emitter/Basis-Komplex aufgesetzt. Für den Emitter/Basis-Komplex sind natürlich verschiedene Ausführungsformen möglich. Eine Möglichkeit besteht zum Beispiel darin, den Basisanschluß zum aktiven Transistor durch einen Innenspacer selbstjustiert herzustellen (siehe zum Beispiel A. W. Wieder, Siemens Forschungs- und Entwicklungsberichte, Band 13, (1984), Seiten 246 ff und J. N. Burghartz et al, IEEE Electron. Device Letters, Band 9, (1988), Seiten 259 ff). In diesem Innenspacerkonzept ist die Herstellung der Basis durch Implantation, Ausdiffusion oder selektive Abscheidung möglich. Eine andere Möglichkeit besteht darin, den Emitter/Basis-Komplex in der aus T. C. Chen et al, IEDM Technical Digest 1988, Seiten 740 ff und D. L. Harame t al, IEEE Electron. Dev. Letters, Band 10 (1989), Seiten 156 ff bekannten Weise durch Selbstjustierung des Basisanschlusses mit einem Außenspacer herzustellen.

Da beim erfindungsgemäßhergestellten Bipolartransistor der aktive Kollektor durch selektive Epitaxie hergestellt wird, nachdem im Substrat die Isolationsoxidbereiche fertiggestellt sind, ist der Bipolartransistor in BICMOS-Konzepte integrierbar. Die Bipolarherstellung erfolgt vollständig unabhängig von der CMOS-Herstellung. Bipolarkomponenten und CMOS-Komponenten können unabhängig voneinander optimiert werden. Der erfindungsgemäß hergestellte Bipolartransistor kann daher jedem CMOS-Prozeß aufgesetzt werden, ohne daß weitere Entwicklungsarbeit am CMOS-Prozeß nötig wäre.

Bei der Herstellung einer BICMOS-Schaltung mit mindestens einem erfindungsgemäßen Bipolartransistor wird die leitfähige Schicht nach der Kanalimplantation und Erzeugung der Gateoxide für die CMOS-Transistoren ganzflächig aufgebracht. Die leitfähige Schicht wird so strukturiert, daß daraus die Gateelektroden und der für die Bipolartransistorherstellung benötigte Bereich der leitfähigen Schicht entsteht. Mit der Isolationsschicht, aus der die den Kollektor umgebende Isolationsstruktur erzeugt wird, werden die fertig prozessierten CMOS-Transistoren abgedeckt. Bei dieser gleichzeitigen Verwendung der leitfähigen Schicht als Gateelektrode und als vergrabene Kollektoranschlußschicht wird im Herstellungsprozeß eine Maske eingespart.

Weitere Ausgestaltungen der Erfindung gehen aus den übrigen Ansprüchen hervor.

Im folgenden wird die Erfindung anhand von Ausführungsbeispielen und anhand der Figuren näher erläutert.
- Figur 1 bis Figur 3: zeigt verschiedene Ausführungsformen des erfindungsgemäß hergestellten Bipolartransistors.
- Figur 4: zeigt eine BICMOS-Anordnung, die einen erfindungsgemäß hergestellten Bipolartransistor enthält.
- Figur 5 bis Figur 14, Figur 15 bis Figur 18: zeigen Herstellschritte für verschiedene erfindungsgemäß hergestellte Bipolartransistoren.
- Figur 19 bis Figur 22: zeigen Herstellschritte für eine BICMOS-Anordnung mit einem erfindungsgemäß hergestellten Bipolar-transistor.

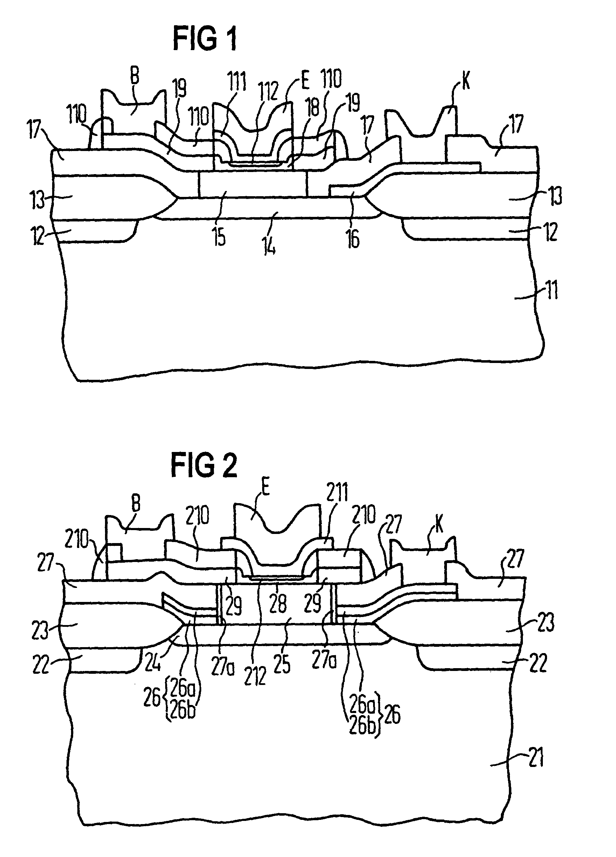

In einem hochohmigen Substrat 11, das zum Beispiel p-dotiert ist, sind Channel-stopper-Bereiche 12 angeordnet (siehe Figur 1). Oberhalb der Channel-stopper-Bereiche 12 sind Isolationsoxidbereiche 13 angeordnet. Als Isolationsoxidbereich 13 wird zum Beispiel eine LOCOS-Isolation oder eine Box-Isolation verwendet. Zwischen den Isolationsoxidbereichen 13 ist im Substrat 11 ein Subkollektor 14 angeordnet. Der Subkollektor 14 ist zum Beispiel n⁺-dotiert.

Oberhalb des Subkollektors 14 ist ein Kollektor 15 angeordnet. Der Kollektor 15 ist zum Beispiel n⁻-dotiert. Seitlich des Kollektors 15 ist auf dem Subkollektor 14 eine vergrabene Kollektoranschlußschicht 16 angeordnet. Die vergrabene Kollektoranschlußschicht 16 ist so angeordnet, daß sie mit dem Kollektor 15 nur über den Subkollektor 14 in Verbindung steht. Die vergrabene Kollektoranschlußschicht 16 erstreckt sich auch auf den neben dem Subkollektor 14 angeordneten Isolationsoxidbereich 13. Die vergrabene Kollektoranschlußschicht 16 ist elektrisch leitend. Die vergrabene Kollektoranschlußschicht 16 besteht zum Beispiel aus n⁺-dotiertem Polysilizium, aus einem Silizid, aus Polyzid, Wolfram oder ähnlichem.

Der Kollektor 15 ist von einer Isolationsstruktur 17 umgeben. In der Höhe schließen die Isolationsstruktur 17 und der Kollektor 15 in etwa miteinander ab. Die Isolationsstruktur 17 reicht seitlich auf die Isolationsoxidbereiche 13 hinaus. Die Isolationsstruktur 17 bedeckt die vergrabene Kollektoranschlußschicht 16 vollständig. Oberhalb der vergrabenen Kollektoranschlußschicht 16 und oberhalb des darunterliegenden Isolationsoxidbereichs 13 ist ein Kontaktloch mit einer Metallisierung als Kollektorkontakt K angeordnet. Auf dem Kollektor 15 ist eine Basis 18 angeordnet. Die Basis 18 ist ringförmig von einem Basisanschluß 19 umgeben. Der Basisanschluß 19 besteht zum Beispiel aus p⁺-dotiertem Polysilizium. Der Basisanschluß 19 ist im wesentlichen auf der Isolationsstruktur 17 angeordnet.

Es ist eine Oxidschicht 110 vorgesehen, die den Basisanschluß 19 vollständig bedeckt. Oberhalb der Basis 18 definiert die Oxidschicht 110 eine Öffnung. Auf der Öffnung ist ein Emitteranschluß 111 aus n⁺-dotiertem Polysilizium angeordnet. Ein Emitter 112 wird durch Ausdiffusion aus dem Emitter 111 erzeugt. In der Oxidschicht 110 ist ein Kontaktloch vorgesehen, das mit einer Metallisierung als Basiskontakt B gefüllt ist. Auf dem Emitteranschluß 111 ist eine Metallisierung als Emitterkontakt E vorgesehen.

Da die vergrabene Kollektoranschlußschicht 16 zu einem Teil über den Isolationsoxidbereich 13 verläuft, wird die Fläche des Subkollektors 14 und damit auch die parasitäre Kollektor/Substrat-Kapazität im Vergleich zum Stand der Technik verkleinert.

In einer weiteren Ausführungsform für einen erfindungsgemäß hergestellten Bipolartransistor (siehe Figur 2) sind in einem Substrat 21, das p-leitend und hochohmig ist, Channel-Stopper-Bereiche 22 angeordnet. Oberhalb der Channel-Stopper-Bereiche 22 sind Isolationsoxidbereiche 23 angeordnet. Im Substrat 21 ist ein Subkollektor 24 angeordnet, der von den Isolationsoxidbereichen 23 umgeben ist. Der Subkollektor 24 ist zum Beispiel n⁺-leitend. Auf dem Subkollektor 24 ist ein Kollektor 25 angeordnet, der n⁻-dotiert ist. Um den Kollektor 25 herum ist eine ringförmige, vergrabene Kollektoranschlußschicht 26 angeordnet. Die vergrabene Kollektoranschlußschicht 26 ist als Doppelschicht ausgebildet. Sie besteht aus einer n⁺-dotierten Polysiliziumschicht 26a und aus einer darauf angeordneten Metallsilizidschicht 26b. Die Polysiliziumschicht 26a steht in direkter Verbindung mit dem Subkollektor 24. Zwischen der vergrabenen Kollektoranschlußschicht 26 und dem Kollektor 25 sind Flankenisolationen 27a zum Beispiel aus Siliziumoxid oder Siliziumnitrid vorgesehen. Dadurch ist der Kollektor 25 nur über den Subkollektor 24 mit der vergrabenen Kollektoranschlußschicht 26 verbunden. Durch die ringförmige Anordnung der vergrabenen Kollektoranschlußschicht wird schon mit einem flachen Subkollektor 24 mit einer Tiefe von nur zum Beispiel 100 nm ein ausreichend kleiner Kollektor-Bahnwiderstand realisiert, ohne daß der Platzverbrauch des Transistors und die parasitäre Kollektor/Substratkapazität erhöht werden.

Oberhalb der vergrabenen Kollektoranschlußschicht 26 ist eine Isolationsstruktur 27 aus zum Beispiel Siliziumoxid angeordnet. Die Isolationsstruktur 27 schließt in der Höhe mit den Flankenisolationen 27a und dem Kollektor 25 ab. In der Isolationsstruktur 27 ist ein Kontaktloch vorgesehen, das mit einer Metallisierung als Kollektorkontakt K gefüllt ist.

Auf dem Kollektor 25 ist eine Basis 28 angeordnet, die zum Beispiel p-dotiert ist. Die Basis 28 ist ringförmig von einem Basisanschluß 29 umgeben, der zum Beispiel p⁺-dotiert ist und aus polykristallinem Silizium besteht. Der Basisanschluß 29 ist mit einer Oxidschicht 210 bedeckt, die eine den Emitterbereich definierende Öffnung aufweist. Auf der Oxidschicht 210 ist ein Emitteranschluß 211 angeordnet, der aus n⁺-dotiertem Polysilizium besteht. Aus dem Emitteranschluß 211 wird durch Ausdiffusion ein Emitter 212 erzeugt. In der Oxidschicht 210 ist ein Kontaktloch vorgesehen, das mit einer Metallisierung als Basiskontakt B gefüllt ist. Auf dem Emitteranschluß 211 ist eine Metallisierung als Emitterkontakt E angeordnet.

Diese Ausführungsform hat den Vorteil, daß der Kollektor 25 zu der vergrabenen Kollektoranschlußschicht 26 selbstjustiert herstellbar ist. Zur selbstjustierten Herstellung wird mit der gleichen Phototechnik, mit der die Isolationsstruktur 27 erzeugt wird, die vergrabene Kollektoranschlußschicht 26 strukturiert. Nach der Erzeugung der Flankenisolationen 27a wird der Kollektor 25 durch selektive Epitaxie hergestellt.

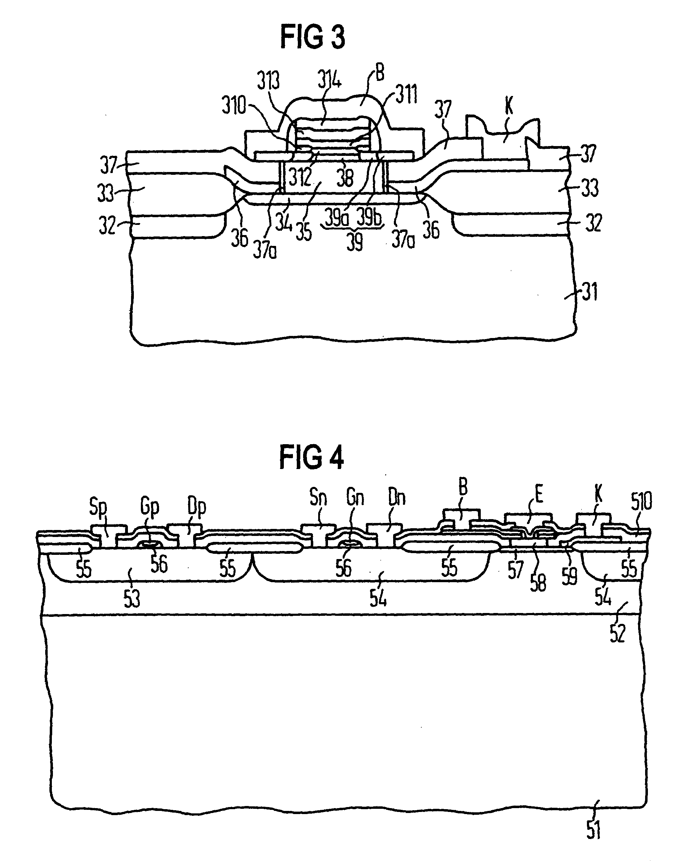

In Figur 3 ist eine weitere Ausführungsform für einen erfindungsgemäß hergestellten Transistor dargestellt. In einem Substrat 31, das hochohmig und p-dotiert ist, sind wiederum Channel-Stopper-Bereiche 32 angeordnet. Oberhalb der Channel-Stopper-Bereiche 32 sind Isolationsoxidbereiche 33 angeordnet. Zwischen den Isolationsoxidbereichen 33 ist ein Subkollektor 34 angeordnet, der n⁺-dotiert ist. Auf dem Subkollektor 34 ist ein Kollektor 35 angeordnet, der n⁻dotiert ist. Der Kollektor 35 ist von Flankenisolationen 37a umgeben, die zum Beispiel aus Siliziumoxid oder Siliziumnitrid bestehen. Zum Kollektor 35 selbstjustiert ist eine vergrabene Kollektoranschlußschicht 36 angeordnet, die außerhalb der Flankenisolationen 37a den Kollektor 35 ringförmig umgibt und die zum Beispiel aus Metallsilizid besteht. Die vergrabene Kollektoranschlußschicht 36 ist teilweise auf dem Subkollektor 34 angeordnet, mit dem sie in Verbindung steht, und teilweise auf dem Isolationsoxidbereich 33. Über den Subkollektor 34 ist der Kollektor 35 mit der vergrabenen Kollektoranschlußschicht 36 verbunden.

Auf der vergrabenen Kollektoranschlußschicht 36 ist eine Isolationsstruktur 37 angeordnet, die zum Beispiel aus Siliziumoxid besteht und die in der Höhe mit den Flankenisolationen 37a und dem Kollektor 35 abschließt. In der Isolationsstruktur 37 ist ein Kontaktloch vorgesehen, das auf die vergrabene Kollektoranschlußschicht 36 reicht und das mit einer Metallisierung als Kollektorkontakt K gefüllt ist. Der bisher beschriebene Komplex ist analog aufgebaut wie der entsprechende Komplex des in Figur 2 gezeigten Ausführungsbeispiels.

Auf dem Kollektor 35 ist eine Basis 38 angeordnet. Die Basis 38 ist zum Beispiel p-dotiert. Die Basis 38 ist von einem Basisanschluß 39 umgeben. Der Basisanschluß 39 wird aus einem ersten Basisanschlußbereich 39a und einem zweiten Basisanschlußbereich 39b gebildet. Der erste Basisanschlußbereich 39a umgibt die Basis 38 ringförmig. Der erste Basisanschlußbereich 39a ist p⁺-dotiert. Der erste Basisanschlußbereich 39a ist wiederum ringförmig umgeben von dem zweiten Basisanschlußbereich 39b, der p⁺⁺-dotiert ist.

Auf dem Basisanschluß 39 ist eine Oxidschicht 310 angeordnet, die so strukturiert ist, daß sie den Grenzbereich zwischen der Basis 38 und dem ersten Basisanschlußbereich 39a sicher abdeckt. Ferner ist die Oxidschicht 310 so strukturiert, daß der zweite Basisanschlußbereich 39b, der p⁺⁺-dotiert ist, von der Oxidschicht 310 unbedeckt ist. Auf der Oxidschicht 310 ist ein Emitteranschluß 311 angeordnet, der aus n⁺-dotiertem Polysilizium besteht und der mit den äußeren Kanten der Oxidschicht 310 abschließt. Aus dem Emitteranschluß 311 wird auf der Basis 38 ein Emitter 312 durch Ausdiffusion erzeugt. Auf dem Emitteranschluß 311 ist eine Metallsilizidschicht 313 angeordnet, auf die außerhalb der gezeigten Schnittebene ein Emitterkontakt reicht. Die Metallsilizidschicht 313 und der Emitteranschluß 311 sind vollständig von einer Oxidstruktur 314 zugedeckt. Die Oxidstruktur 314 besteht aus einer die Metallsilizidschicht 313 bedeckenden Schicht und aus die Flanken bedeckenden Flanken. Es ist ein metallischer Basiskontakt vorgesehen, der den gesamten freiliegenden Bereich des zweiten Basisanschlußbereiches 39b und des ersten Basisanschlußbereiches 39a sowie die Oxidstruktur 314 überdeckt.

In Figur 4 ist eine BICMOS-Anordnung dargestellt. Auf einem p⁺-dotierten Siliziumsubstrat 51 ist eine p⁻-dotierte Epitaxieschicht 52 angeordnet. In der Epitaxieschicht 52 sind eine n-dotierte Wanne 53 und zwei p-dotierte Wannen 54 angeordnet. An den Rändern der Wannen 53, 54 sind Isolationsoxidbereiche 55 vorgesehen zur sicheren Trennung benachbarter Transistoren. In der n-dotierten Wanne 53 ist ein p-Kanal-Transistor angeordnet, dessen Einzelheiten aus Gründen der Übersichtlichkeit in der Zeichnung nicht wiedergegeben sind. Der p-Kanal-Transistor weist einen Source-Kontakt Sp und einen Drain-Kontakt Dp auf. Der p-Kanal-Transistor weist ferner ein Gateoxid 56 und eine Gateelektrode Gp auf. In einer ersten p-dotierte Wanne 54a ist ein n-Kanal-Transistor angeordnet, dessen Einzelheiten wiederum aus Gründen der Übersichtlichkeit in der Figur nicht dargestellt sind. Der n-Kanal-Transistor weist einen Source-Kontakt Sn und einen Drain-Kontakt Dn auf. Der n-Kanal-Transistor weist weiterhin ein Gateoxid 56 und eine Gateelektrode Gn auf.

Zwischen den p-dotierten Wannen 54 ist an der Oberfläche der Epitaxieschicht 52 ein erfindungsgemäß hergestellter Bipolartransistor angeordnet. Dabei wirken die p-dotierten Wannen 54 als Channel-Stopper-Bereiche. Zwischen den Isolationsoxidbereichen ist ein Subkollektor 57, der n⁺-dotiert ist, angeordnet. Auf dem Subkollektor 57 ist ein Kollektor 58, der n⁻-dotiert ist und eine vergrabene Kollektoranschlußschicht 59 angeordnet. Die vergrabene Kollektoranschlußschicht 59 besteht zum Beispiel aus n⁺-dotiertem Polysilizium. Die Gateelektroden Gp, Gn bestehen aus demselben Material wie die vergrabene Kollektoranschlußschicht 59, zum Beispiel aus n⁺-dotiertem Polysilizium. Daher können die Gateelektroden Gp und Gn in demselben Schritt hergestellt werden wie die vergrabene Kollektoranschlußschicht 59, was eine Maskenersparnis bedeutet. Es ist eine Isolationsschicht 510 vorgesehen, die den p-Kanal-Transistor, den n-Kanal-Transistor und die vergrabene Kollektoranschlußschicht 59 bedeckt und die den Kollektor 58 umgibt. In der Isolationsschicht 510 sind Kontaktlöcher vorgesehen, über die die Source-Kontakte Sp, Sn und die Drain-Kontakte Dp, Dn mit den Source- bzw. Drain-Gebieten in Kontakt stehen. Auf dem Kollektor 58 ist zum Beispiel ein Basis/Emitter-Komplex in Doppelpolysiliziumtechnologie angeordnet, wie er zum Beispiel aus A. W. Wieder, Siemens-Forschungs- und Entwicklungsberichte, Band 13, (1984), Seiten 246 ff bekannt ist.

Die Kontaktlochätzung für die Source-Kontakte Sp, Sn, die Drain-Kontakte Dp, Dn und für den Basiskontakt B, den Emitterkontakt E und den Kollektorkontakt K können in einem Prozeßschritt mit einer Maske geätzt werden.

Da der Bipolartransistor an der Oberfläche der Epitaxieschicht 52 angeordnet ist und da der Kollektor 58 durch selektive Epitaxie erzeugt wird, sind die CMOS-Komponenten (p-Kanal-Transistor und n-Kanal-Transistor) unabhängig vom Bipolartransistor optimierbar. Für den jeweiligen Anwendungsfall werden nach dem Baukastenprinzip der beste p-Kanal-Transistor, der beste n-Kanal-Transistor und der beste Bipolartransistor miteinander kombiniert.

Im folgenden wird anhand von Ausführungsbeispielen die Herstellung des erfindungsgemäß hergestellten Transistors näher erläutert. Dem Ausführungsbeispiel wird eine 0,4 µm Photolithographie mit einer Justiertoleranz von etwa 0,13 µm zugrunde gelegt.

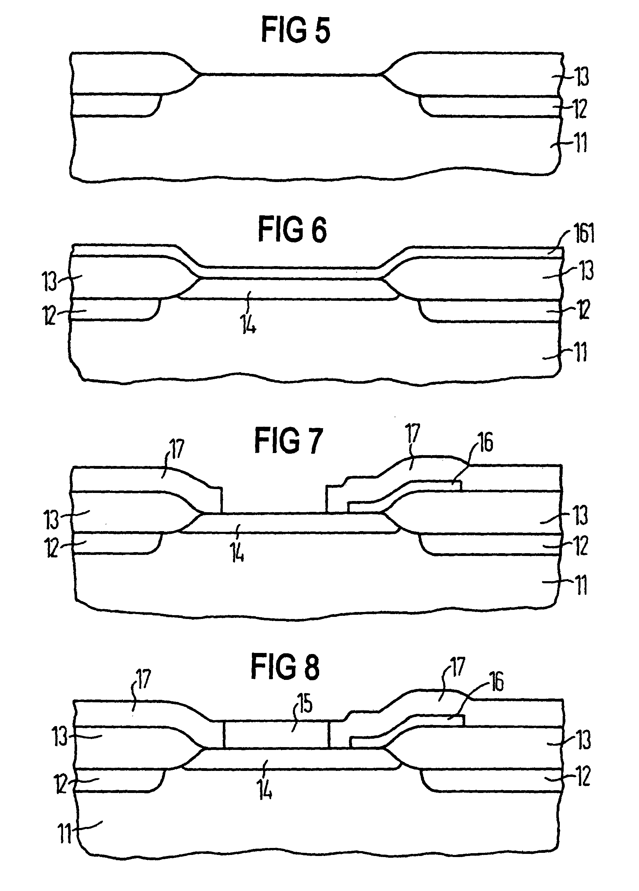

Zur Herstellung des in Figur 1 dargestellten Bipolartransistors werden in dem Substrat 11 die Channel-Stopper-Bereiche 12 durch Implantation und die Isolationsoxidbereiche 13 zum Beispiel durch eine LOCOS-Technik hergestellt (siehe Figur 5). Als Substrat 11 wird zum Beispiel schwach p-dotiertes (100) Czochralski-Silizium verwendet. Die Dicke der Isolationsoxidbereiche 13 beträgt zum Beispiel 0,4 µm. Der auf der Substratoberfläche 11 von den Isolationsoxidbereichen 13 unbedeckte Bereich hat eine Größe von zum Beispiel 1,6 x 1,6 µm².

Auf die Struktur wird ganzflächig eine leitfähige Schicht 161 aufgebracht (siehe Figur 6). Die leitfähige Schicht 161 weist eine Dicke von zum Beispiel 150 nm auf. Die leitfähige Schicht 161 besteht zum Beispiel aus einem Metallsilizid, n⁺-dotiertem Polysilizium, einem Polyzid, Wolfram oder ähnlichem. Die leitfähige Schicht 161 wird mit n-dotierenden Ionen implantiert. In einem Temperaturschritt wird der Subkollektor 14 durch Ausdiffusion der Dotierstoffe aus der leitfähigen Schicht 161 in das Substrat 11 erzeugt. Die leitfähige Schicht 161 hat im fertigen Transistor die Funktion, den Subkollektor 14 an die Leiterbahnen anzuschließen.

Mit Hilfe einer Phototechnik wird die leitfähige Schicht 161 so strukturiert, daß daraus die vergrabene Kollektoranschlußschicht 16 entsteht (siehe Figur 7). Die vergrabene Kollektoranschlußschicht 16 ist an einer Seite des Subkollektors 14 so angeordnet, daß sie auf den anschließenden Isolationsoxidbereich 13 hinüberreicht. Auf die Oberfläche der Struktur wird ganzflächig eine Isolationsschicht mit einer Dicke von zum Beispiel 300 nm abgeschieden. Mit Hilfe einer weiteren Phototechnik wird die Isolationsschicht so strukturiert, daß die Isolationsstruktur 17 entsteht. Die Isolationsstruktur 17 enthält einen Bereich, in dem die Oberfläche des Subkollektors 14 freigelegt ist.

Nach Durchführung von allgemein bekannten, für die selektive Epitaxie nötigen Reinigungsschritten wird der Kollektor 15 durch selektive epitaktische Abscheidung auf der freiliegenden Oberfläche des Subkollektors 14 erzeugt (siehe Figur 8). Der von der Isolationsstruktur 17 definierte Bereich wird dabei bis zur oberen Kante aufgefüllt. Der Kollektor 15 wird n-dotiert. Die Dotierstoffkonzentration beträgt zum Beispiel 2 x 10¹⁶ cm⁻³.

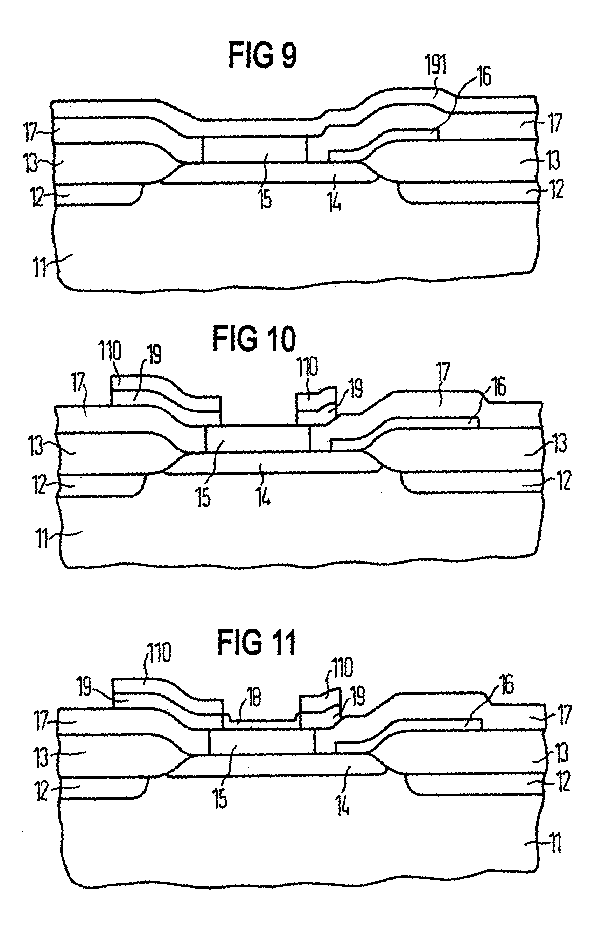

Auf die Oberfläche der Struktur wird ganzflächig eine Siliziumschicht 191 aufgebracht (siehe Figur 9). Die Siliziumschicht 191 wird mit p-dotierenden Ionen implantiert. Die Dicke der Siliziumschicht 191 beträgt zum Beispiel 150 nm. Die Abscheidung der Siliziumschicht 191 erfolgt zum Beispiel polykristallin oder amorph in einem Ofen. Es ist für das weitere Herstellverfahren jedoch vorteilhaft, die Schicht in einem Epitaxiereaktor ganzflächig abzuscheiden, so daß auf den Siliziumbereichen, das heißt auf der Oberfläche des Kollektors 15, eine monokristalline Schicht mit der Kristallorientierung des Kollektors 15 und damit des Substrates 11 entsteht. Nur auf der Oxidunterlage, das heißt auf der Isolationsstruktur 17, wächst das abgeschiedene Siliziummaterial polykristallin auf. Ein solches Vorgehen ist vorteilhaft, um ein möglichst korngrenzenfreies Aufwachsen der später selektiv abzuscheidenden Basis zu gewährleisten (siehe Beschreibung zu Figur 11).

Auf die Siliziumschicht 191 wird eine Oxidschicht ganzflächig in einer Dicke von zum Beispiel 150 nm abgeschieden. Nach einer Phototechnik wird die Doppelschicht bestehend aus der Oxidschicht und der Siliziumschicht 191 strukturiert. Dabei wird aus der Siliziumschicht 191 der Basisanschluß 19. Aus der Oxidschicht wird ein Teil der den Basisanschluß 19 bedekkenden Oxidschicht 110. Der Basisanschluß 19 ist ringförmig und definiert den Bereich für die Basis und den Emitter (siehe Figur 10).

Nach den für die selektive Epitaxie nötigen Reinigungsschritten wird die p-dotierte Basis 18 selektiv in einem Epitaxiereaktor in einer Schichtdicke von zum Beispiel 100 nm auf dem Kollektor 15 abgeschieden (siehe Figur 11). Bei der selektiven Epitaxie wächst die Basis 18 sowohl auf der Oberfläche des Kollektors 15 als auch an den daran angrenzenden Oberflächen des Basisanschlusses 19 auf. Wie in Verbindung mit Figur 9 bereits erwähnt, ist es dabei günstig, wenn die für den Basisanschluß dienende Siliziumschicht 191 in einem Epitaxiereaktor abgeschieden worden ist. In diesem Fall sind die Bereiche des Basisanschlusses 19, die unmittelbar auf der Oberfläche des Kollektors 15 angeordnet sind, monokristallin mit der Orientierung des Kollektors 15. Beim Aufwachsen der Basis 18 haben dann auch diejenigen Bereiche, die von den angrenzenden Oberflächen des Basisanschlusses 19 aus wachsen, definierte Kristallorientierungen. Da die Basis 18 durch selektive Epitaxie erzeugt wird, wird im Vergleich zu einer zum Beispiel implantierten Basis eine vertikale Strukturverkleinerung des Emitter/Basis-Komplexes erzielt. Die Basis 18 wird p-dotiert.

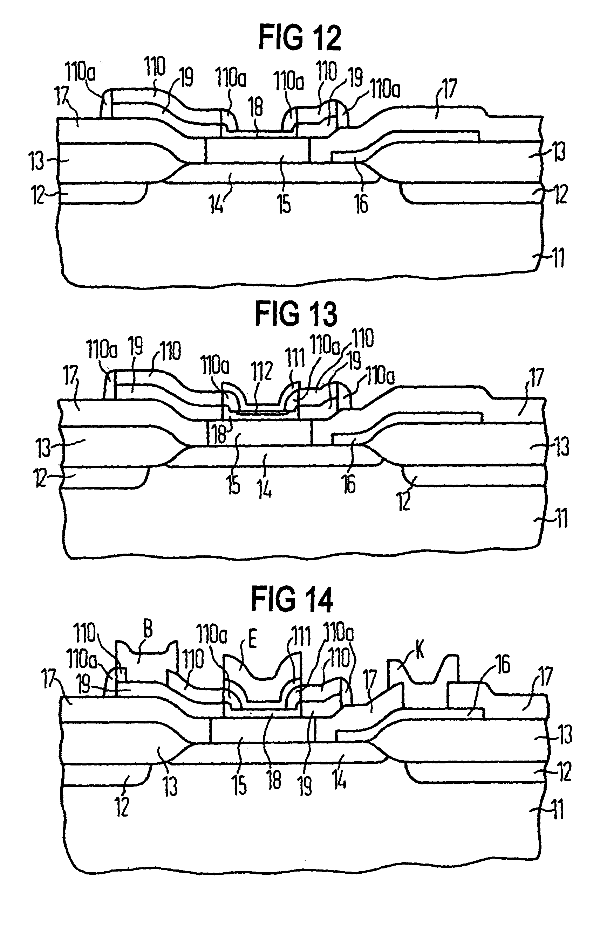

Im nächsten Schritt werden Spacer 110a an den Flanken des Basisanschlusses 19 erzeugt (siehe Figur 12). Dazu wird eine weitere Oxidschicht in einer Dicke von zum Beispiel 150 nm ganzflächig abgeschieden und mittels eines anisotropen Trokkenätzschrittes zurückgeätzt. Die an die Basis 18 angrenzenden Spacer 110a führen zur Selbstjustierung des Basisanschlusses 19 zum herzustellenden Emitter. Die an die Basis 18 angrenzenden Spacer 110a verlegen ferner eventuell am Rand der Basis 18 entstandene Korngrenzen in inaktive Transistorbereiche.

Auf die Oberfläche der Struktur wird eine Polysiliziumschicht in einer Dicke von zum Beispiel 100 nm aufgebracht. Die Polysiliziumschicht wird mit einer Dosis φ = 1 x 10¹⁶ cm⁻² mit n-dotierenden Ionen implantiert. Durch die Strukturierung der Polysiliziumschicht mit Hilfe einer unkritischen Phototechnik wird der Emitteranschluß 111 so erzeugt, daß er die an der Basis 18 angrenzenden Spacer 110a sowie die dazwischenliegende Siliziumoberfläche bedeckt (siehe Figur 13). In einem Temperaturschritt wird der Emitter 112 erzeugt. Der Emitter 112 wird zum Beispiel 30 nm in das darunterliegende einkristalline Silizium eingetrieben.

Mit Hilfe einer Phototechnik werden in der Oxidschicht 117 und in der Isolationsstruktur 17 Kontaktlöcher für den Basis- und den Kollektoranschluß geöffnet (siehe Figur 14). Der Basiskontakt B, der Emitterkontakt E und der Kollektorkontakt K werden durch Metallisierung erzeugt.

Im folgenden wird ein Ausführungsbeispiel gegeben für die Herstellung eines Transistors mit einem ringförmigen Kollektoranschluß, bei dem der Kollektor zum Kollektoranschluß selbstjustiert hergestellt ist.

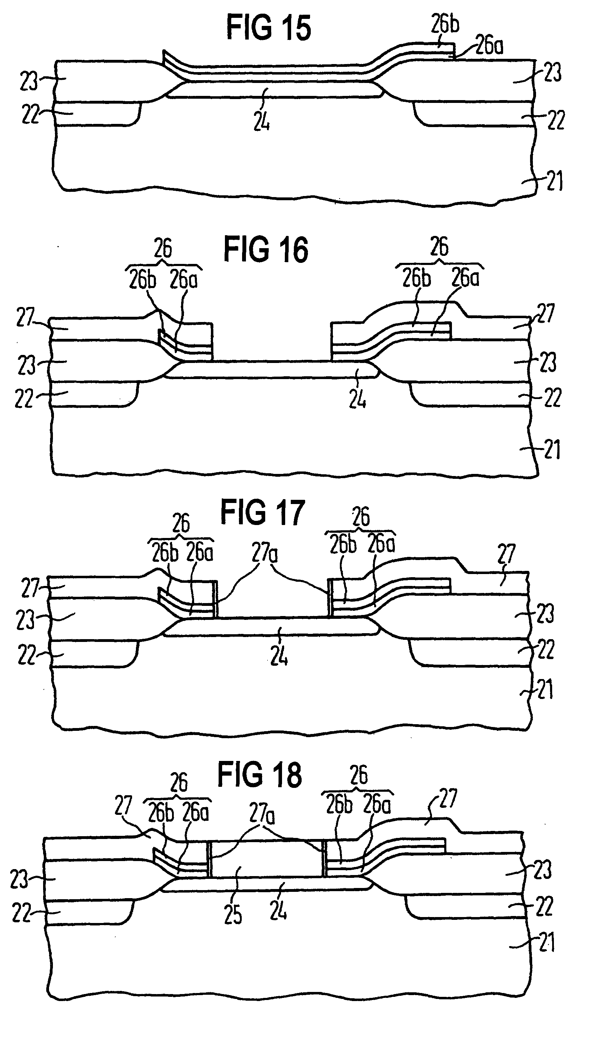

Als Substrat 21 wird schwach p-dotiertes (100) Czochralski-Silizium verwendet (siehe Figur 15). In dem Substrat 21 werden durch Implantation Channel-Stopper-Bereiche 22 erzeugt. Die Isolationsoxidbereiche 23 werden zum Beispiel mit einer LOCOS-Technik erzeugt. Die Isolationsoxidbereiche 23 haben eine Dicke von zum Beispiel 0,4 um. Durch die Isolationsoxidbereiche 23 wird eine freiliegende Oberfläche des Substrats 21 in einer Größe von zum Beispiel 1,6 x 1,6 µm² definiert.

Es wird ganzflächig eine Polysiliziumschicht 26a in einer Dicke von zum Beispiel 80 nm aufgebracht. Die Polysiliziumschicht 26a wird mit einer Dosis von φ = 2 x 10¹⁶ cm⁻² mit n-dotierenden Ionen implantiert. Auf die Polysiliziumschicht 26a wird eine Metallsilizidschicht 26b mit einer Dicke von zum Beispiel 80 nm aufgetragen. Der Subkollektor 24 wird in einem Temperaturschritt durch Ausdiffusion aus der Polysiliziumschicht 26a in das Substrat 21 erzeugt.

Mit Hilfe einer Phototechnik wird die Doppelschicht bestehend aus der Polysiliziumschicht 26a und der Metallsilizidschicht 26b so strukturiert, daß sie den Subkollektor 24 vollständig überdeckt und sich auf die Flanken der daran angrenzenden Isolationsoxidbereiche 23 erstreckt (vergleiche Figur 15).

Auf die Oberfläche der Struktur wird in einer Dicke von zum Beispiel 200 nm ganzflächig eine Oxidschicht abgeschieden. Mit Hilfe einer Phototechnik werden gleichzeitig die Oxidschicht und die aus der Polysiliziumschicht 26a und der Metallsilizidschicht 26b bestehende Doppelschicht strukturiert. Bei dieser Strukturierung entsteht die ringförmige, vergrabene Kollektoranschlußschicht 26 und die Isolationsstruktur 27 (siehe Figur 16). Bei der Strukturierung wird die Oberfläche des Subkollektors 24 innerhalb der ringförmigen vergrabenen Kollektoranschlußschicht 26 und der Isolationsstruktur 27 freigelegt.

Um während der nachfolgenden selektiven Epitaxie zur Erzeugung des Kollektors 25 eine Nukleation von Siliziumatomen an der vergrabenen Kollektoranschlußschicht 26, die aus der Polysiliziumschicht 26a und der Metallsilizidschicht 26b zusammengesetzt ist, zu vermeiden, werden die den freigelegten Bereich des Subkollektors 24 umgebenden Flanken mit Flankenisolationen 27a ausgekleidet. Die Flankenisolationen 27a bestehen zum Beispiel aus Siliziumoxid oder Siliziumnitrid (siehe Figur 17).

Nach Durchführung der für die selektive Epitaxie nötigen Reinigungsschritte wird der n-dotierte Kollektor 25 durch selektive Epitaxie auf der freiliegenden Oberfläche des Subkollektors 24 erzeugt (siehe Figur 18). Der Kollektor 25 füllt den Bereich innerhalb der Flankenisolationen 27a vollständig aus. In der Höhe schließen die Isolationsstrukturen 27, die Flankenisolationen 27a und der Kollektor 25 ab.

Auf die in Figur 18 dargestellte Struktur, die den Kollektor mit angeschlossenem Kollektoranschluß enthält, können verschiedene Variationen für den Emitter/Basis-Komplex aufgesetzt werden. Eine Möglichkeit besteht darin, den Basis/Emitter-Komplex analog dem anhand von Figur 9 bis Figur 14 beschriebenen herzustellen. Eine andere Möglichkeit, die zu der in Figur 3 gezeigten Transistorstruktur führt, besteht darin, den Emitter/Basis-Bereich nach dem aus T. C. Chen et al, IEDM Technical Digest 1988, Seiten 740 ff und D. L. Harame et al IEEE Electron. Dev. Letters, Band 10 (1989), Seiten 156 ff, bekannten Verfahren herzustellen.

Im folgenden wird ein Ausführungsbeispiel für ein Herstellverfahren für eine BICMOS-Anordnung gegeben. Dem Ausführungsbeispiel liegt eine 0,8 µm-Photolithographie mit einer Justiertoleranz von 0,3 µm zugrunde.

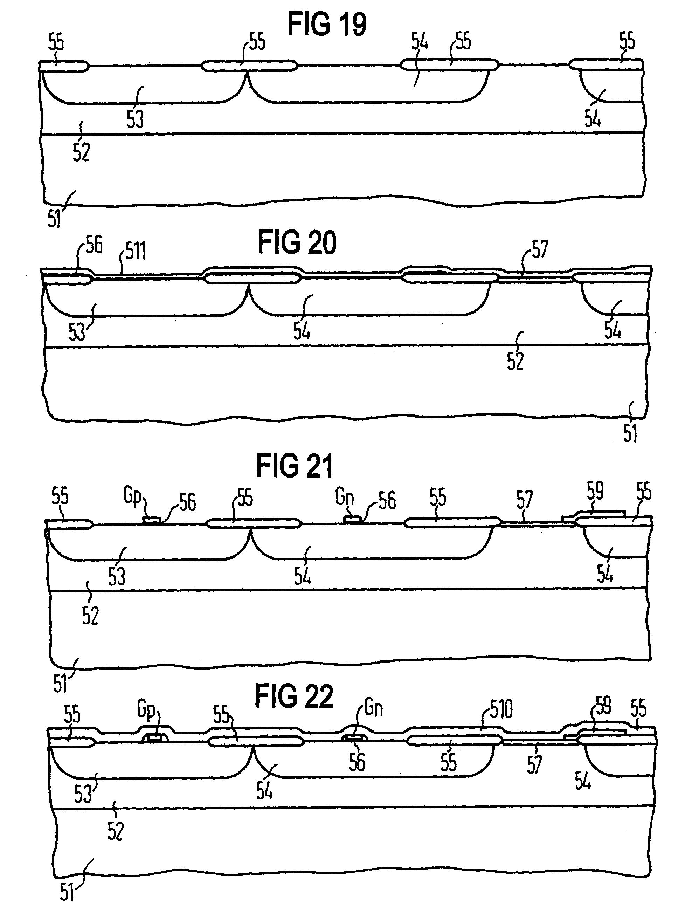

Auf einem p-dotierten Substrat 51 wird die Epitaxieschicht 52 als p⁻-dotierte Epitaxieschicht aufgebracht. In der Epitaxieschicht 52 werden n-dotierte Wannen 53 und p-dotierte Wannen 54 zum Beispiel nach Herstellverfahren hergestellt, die aus L. C. Parillo et al, IEDM Technical Digest, 1980, Seiten 752 ff und M. L. Chen et al, IEDM Technical Digest, 1986, Seiten 256 ff bekannt sind. Während der Implantation der p-dotierten Wannen 54 wird dabei der Bipolarbereich mit einer zusätzlichen Maske abgedeckt, um die Kollektor/Substrat-Kapazität zu reduzieren. Zur Trennung aktiver Transistorbereiche werden Isolationsoxidbereiche 55 hergestellt (siehe Figur 19).

Auf die Oberfläche der Struktur wird ganzflächig das Gateoxid 56 in einer Dicke von zum Beispiel 20 nm aufgebracht (siehe Figur 20). Mit Hilfe einer Phototechnik wird das Gateoxid im Bipolar-Bereich wieder entfernt. Danach erfolgt das Abscheiden einer zum Beispiel 300 nm dicken Polysiliziumschicht 511, die mit n-dotierenden Atomen belegt wird. In einem Temperaturschritt wird der Subkollektor 57 in die p⁻-dotierte Epitaxieschicht 52 eindiffundiert.

Mit Hilfe einer Phototechnik werden die Polysiliziumschicht 511 und das Gateoxid 56 gemeinsam strukturiert (siehe Figur 21). Dabei werden die Gateelektroden Gp, Gn und die vergrabene Kollektoranschlußschicht 59 aus der Polysiliziumschicht 511 hergestellt. Durch die gleichzeitige Herstellung der Gateelektroden Gp, Gn und der vergrabenen Kollektoranschlußschicht 59 wird eine Maske eingespart.

Die CMOS-Transistoren sind danach bis auf die Herstellung der Metallisierung fertiggestellt. Es wird ganzflächig eine zum Beispiel 500 nm dicke Isolationsschicht 510 abgeschieden. Die Isolationsschicht 510 besteht zum Beispiel aus Siliziumoxid. Die Isolationsschicht 510 schützt die CMOS-Transistoren vor den nachfolgenden Prozeßschritten zur Bipolar-Herstellung (siehe Figur 22).

In den nachfolgenden Prozeßschritten wird die Isolationsschicht 510 so strukturiert, daß die den Kollektor begrenzende Isolationsstruktur entsteht. Es folgen die Prozeßschritte, die zum Beispiel anhand der Figuren 5 bis 13 beschrieben wurden.

Nach Öffnung der Kontaktlöcher werden die CMOS- und die Bipolar-Transistoren gleichzeitig metallisiert. Die fertige Struktur entspricht der in Figur 4 dargestellten.

## Patentansprüche

1. Verfahren zur Herstellung eines integrierten Bipolartransistors,
- bei dem in einem Halbleitersubstrat (11) zur Trennung benachbarter Transistoren Isolationsoxidbereiche (13) gebildet werden, die eine freiliegende Oberfläche des Substrats definieren,
- bei dem nach der Erzeugung der Isolationsoxidbereiche (13) auf die Oberfläche der Struktur ganzflächig eine dotierte, leitfähige Schicht (161) abgeschieden wird,
- bei dem durch Ausdiffusion aus der leitfähigen Schicht (161) in einem Temperaturschritt in dem Substrat ein Subkollektorbereich (14) erzeugt wird, der von den Isolationsoxidbereichen (13) umgeben ist,
- bei dem nach einer Photolithographie die leitfähige Schicht (161) strukturiert wird, so daß daraus eine leitfähige Kollektoranschlußschicht (16) entsteht, die mindestens teilweise auf den Isolationsoxidbereichen (13) angeordnet ist und die mit dem Subkollektorbereich (14) in direktem Kontakt elektrisch verbunden ist,
- bei dem ganzflächig eine Isolationsschicht aus isolierendem Material erzeugt wird, aus der durch Strukturierung nach einer weiteren Photolithographie eine Isolationsstruktur (17) gebildet wird, die einen aktiven Transistorbereich definiert, die die Lage für einen Kollektorbereich (15) bestimmt, die die Kollektoranschlußschicht (16) bedeckt und die Flanken aufweist, die innerhalb der Isolationsoxidbereiche (13) auf den Subkollektorbereich (14) reichen,
- bei dem ein Kollektorbereich (15) durch selektive Epitaxie nur innerhalb der Isolationsstruktur (17) erzeugt wird, so daß die Isolationsstruktur (17) den Kollektorbereich (15) seitlich isoliert und der Kollektorbereich (15) nur über den Subkollektorbereich (14) mit der Kollektoranschlußschicht (16) elektrisch verbunden ist,
- bei dem die Isolationsstruktur (17) so erzeugt wird, daß die Oberfläche und die Flanken der Kollektoranschlußschicht (16) vollständig mit isolierendem Material bedeckt sind, wodurch während der selektiven Epitaxie eine Nukleation an der Kollektoranschlußschicht (16) verhindert wird,
- bei dem der Subkollektorbereich (14) vom gleichen Leitfähigkeitstyp wie der Kollektorbereich (15) jedoch höher als der Kollektorbereich (15) dotiert wird.

2. Verfahren zur Herstellung eines integrierten Bipolartransistors,
- bei dem in einem Halbleitersubstrat (21) zur Trennung benachbarter Transistoren Isolationsoxidbereiche (23) gebildet werden, die eine freiliegende Oberfläche des Substrats definieren,
- bei dem nach der Erzeugung der Isolationsoxidbereiche (23) auf die Oberfläche der Struktur ganzflächig eine dotierte, leitfähige Schicht (26a, 26b) abgeschieden wird,
- bei dem durch Ausdiffusion aus der leitfähigen Schicht (26a, 26b) in einem Temperaturschritt in dem Substrat ein Subkollektorbereich (24) erzeugt wird, der von den Isolationsoxidbereichen (23) umgeben ist,
- bei dem ganzflächig eine Isolationsschicht aus isolierendem Material aufgebracht wird,
- bei dem nach einer Photolithographie die leitfähige Schicht (26a, 26b) und die Isolationsschicht so strukturiert werden, daß aus der leitfähigen Schicht (26a, 26b) eine ringförmige, leitfähige Kollektoranschlußschicht (26) und aus der Isolationsschicht eine Isolationsstruktur (27), die einen aktiven Transistorbereich definiert, entstehen, daß die Kollektoranschlußschicht (26) und die Isolationsstruktur (27) am Rand des Subkollektorbereichs (24) angeordnet sind und eine gemeinsame, senkrechte, die Lage des Kollektorbereichs (25) bestimmende Flanke aufweisen, und daß die Kollektoranschlußschicht (26) mindestens teilweise auf den Isolationsoxidbereichen (23) angeordnet ist und mit dem Subkollektorbereich (24) in direktem Kontakt elektrisch verbunden ist,
- bei dem die die Lage des Kollektorbereichs (25) bestimmende Flanke mit einer dünnen Flankenisolation (27a) aus isolierendem Material ausgekleidet wird,
- bei dem ein Kollektorbereich (25) durch selektive Epitaxie nur innerhalb der Isolationsstruktur (27) erzeugt wird, so daß die Isolationsstruktur den Kollektorbereich (25) seitlich isoliert und der Kollektorbereich (25) nur über den Subkollektorbereich (24) mit der Kollektoranschlußschicht (26) elektrisch verbunden ist, wobei durch die Flankenisolation (27a) eine Nukleation an der vergrabenen Kollektoranschlußschicht (26) während der selektiven Epitaxie verhindert wird,
- bei dem der Subkollektorbereich (24) vom gleichen Leitfähigkeitstyp wie der Kollektorbereich (25) jedoch höher als der Kollektorbereich (25) dotiert wird.

3. Verfahren nach Anspruch 1 oder 2,
**gekennzeichnet durch** folgende Schritte:
a) auf dem Kollektorbereich (15, 25) und der ihn umgebenden Isolationsstruktur (17, 27) wird ein ringförmiger Basisanschluß (19, 29) erzeugt,
b) innerhalb des ringförmigen Basisanschlusses (19, 29) wird auf dem Kollektorbereich (15, 25) **durch** selektive Epitaxie ein Basisbereich (18, 28) hergestellt.

4. Verfahren nach Anspruch 3,
**dadurch gekennzeichnet,**
**daß** der Basisanschluß (19, 29) ganzflächig durch Abscheidung und anschließende Strukturierung erzeugt wird.

5. Verfahren zur Herstellung einer Bipolartransistoren und CMOS-Transistoren enthaltenden Schaltung mit mindestens einem nach Anspruch 1 oder 2 hergestellten Bipolartransistor mit folgenden Schritten:
a) nach einer Kanalimplantation und Erzeugung von Gateoxiden (56) für die CMOS-Transistoren wird ganzflächig eine leitfähige Schicht (511) aufgebracht,
b) die leitfähige Schicht (56) wird so strukturiert, daß daraus Gateelektroden (Gp, Gn) für die CMOS-Transistoren und die vergrabene Kollektoranschlußschicht (59) für den Bipolartransistor entstehen,
c) die CMOS-Transistoren werden bis auf die Herstellung einer Metallisierung fertiggestellt,
d) es wird ganzflächig eine Isolationsschicht (510) aufgebracht, aus der in späteren Prozeßschritten die Isolationsstruktur des Bipolartransistors gebildet wird und die die fertig prozessierten CMOS-Transistoren abdeckt.

## Claims

1. Method for fabricating an integrated bipolar transistor,
- in which insulation oxide regions (13) are formed in a semiconductor substrate (11) for the purpose of isolating adjacent transistors, which regions define an uncovered surface of the substrate,
- in which, after the production of the insulation oxide regions (13), a doped, conductive layer (161) is deposited over the whole area of the surface of the structure,
- in which a subcollector region (14) is produced by outdiffusion from the conductive layer (161) in a thermal step in the substrate, which subcollector region is surrounded by the insulation oxide regions (13),
- in which the conductive layer (161) is patterned according to a photolithography to produce from it a conductive collector terminal layer (16), which is arranged at least partly on the insulation oxide regions (13) and is electrically connected in direct contact with the subcollector region (14);
- in which an insulation layer made of insulating material is produced over the whole area, from which insulation layer, by means of patterning according to a further photolithography, an insulation structure (17). is formed, which defines an active transistor region, which determines the position for a collector region (15), which covers the collector terminal layer (16) and which has side walls which extend within the insulation oxide regions (13) to the subcollector region (14),
- in which a collector region (15) is produced by selective epitaxy only within the insulation structure (17), with the result that the insulation structure (17) laterally insulates the collector region (15) and the collector region (15) is electrically connected to the collector terminal layer (16) only via the subcollector region (14),
- in which the insulation structure (17) is produced in such a way that the surface and the side walls of the collector terminal layer (16) are completely covered with insulating material, thereby preventing nucleation at the collector terminal layer (16) during the selective epitaxy,
- in which the subcollector region (14) is doped by the same conductivity type as the collector region (15) but more highly than the collector region (15).

2. Method for fabricating an integrated bipolar transistor,
- in which insulation oxide regions (23) are formed in a semiconductor substrate (21) for the purpose of isolating adjacent transistors, which regions define an uncovered surface of the substrate,
- in which, after the production of the insulation oxide regions (23), a doped, conductive layer (26a, 26b) is deposited over the whole area of the surface of the structure,
- in which a subcollector region (24) is produced by outdiffusion from the conductive layer (26a, 26b) in a thermal step in the substrate, which subcollector region is surrounded by the insulation oxide regions (23),
- in which an insulation layer made of insulating material is applied over the whole area,
- in which the conductive layer (26a, 26b) and the insulation layer are patterned according to a photolithography in such a way that an annular, conductive collector terminal layer (26) is produced from the conductive layer (26a, 26b) and an insulation structure (27), which defines an active transistor region, is produced from the insulation layer, that the collector terminal layer (26) and the insulation structure (27) are arranged at the edge of the subcollector region (24) and have a common, vertical side wall which determines the position of the collector region (25), and that the collector terminal layer (26) is arranged at least partly on the insulation oxide regions (23) and is electrically connected in direct contact with the subcollector region (24),
- in which the side wall which determines the position of the collector region (25) is lined with a thin side wall insulation (27a) made of insulating material,
- in which a collector region (25) is produced by selective epitaxy only within the insulation structure (27), with the result that the insulation structure laterally insulates the collector region (25) and the collector region (25) is electrically connected to the collector terminal layer (26) only via the subcollector region (24), the side wall insulation (27a) preventing nucleation at the buried collector terminal layer (26) during the selective epitaxy,
- in which the subcollector region (24) is doped by the same conductivity type as the collector region (25) but more highly than the collector region (25).

3. Method according to Claim 1 or 2, **characterized by** the following steps:
a) an annular base terminal (19, 29) is produced on the collector region (15, 25) and the insulation structure (17, 27) surrounding it,
b) within the annular base terminal (19, 29), a base region (18, 28) is fabricated on the collector region (15, 25) by selective epitaxy.

4. Method according to Claim 3,
**characterized in that** the base terminal (19, 29) is produced over the whole area by deposition and subsequent patterning.

5. Method for fabricating a circuit containing bipolar transistors and CMOS transistors and having at least one bipolar transistor fabricated according to Claim 1 or 2, having the following steps:
a) after a channel implantation and the production of gate oxides (56) for the CMOS transistors, a conductive layer (511) is applied over the whole area,
b) the conductive layer (56) is patterned in such a way as to produce from it gate electrodes (Gp, Gn) for the CMOS transistors and the buried collector terminal (59) for the bipolar transistor,
c) the CMOS transistors are completed except for the fabrication of a metallization layer,
d) an insulation layer (510) is applied over the whole area, from which insulation layer, in later process steps, the insulation structure of the bipolar transistor is formed and which insulation layer covers the finished processed CMOS transistors.

## Revendications

1. Procédé de fabrication d'un transistor bipolaire intégré,
- dans lequel on forme dans un substrat (11) semi-conducteur pour la séparation de transistors voisins des zones (13) d'oxyde d'isolement qui définissent une surface dégagée du substrat,
- dans lequel, après l'obtention des zones (13) d'oxyde d'isolement, on dépose sur toute la surface de la structure une couche (161) conductrice dopée,
- dans lequel par diffusion de la couche (161) conductrice, on produit dans un stade de traitement thermique dans le substrat une zone (14) de sous-collecteur qui est entourée des zones (13) d'oxyde d'isolement,
- dans lequel, après une photolithographie, on structure la couche (161) conductrice de manière à y former une couche (16) collectrice de borne de collecteur qui est disposée au moins en partie sur les zones (13) d'oxyde d'isolement et qui est reliée électriquement en contact direct avec la zone (14) de sous-collecteur,
- dans lequel, on produit sur toute la surface une couche d'isolement en matière isolante dans laquelle on forme par structuration après une autre photolithographie une structure (17) d'isolement qui définit une zone active de transistor, qui détermine la position d'une zone (15) de collecteur, qui recouvre la couche (16) de borne de collecteur et qui présente des flancs qui vont au sein de la zone (13) d'oxyde d'isolement jusqu'à la zone (14) de sous-collecteur,
- dans lequel, on produit une zone (15) de collecteur par épitaxie sélective seulement au sein de la structure (17) d'isolement de sorte que la structure (17) d'isolement isole latéralement la zone (15) de collecteur et relie électriquement la zone (15) de collecteur seulement par la zone (14) de sous-collecteur à la couche (16) de borne de collecteur,
- dans lequel, on produit la structure (17) d'isolement de façon que la surface et les flancs de la couche (16) de borne de collecteur soit recouverte entièrement de matière isolante, de sorte que l'on empêche pendant l'épitaxie sélective une nucléation sur la couche (16) de borne de collecteur,
- dans lequel, on donne à la zone (14) de sous-collecteur un dopage de même type de conductivité que celui de la zone (15) de collecteur mais plus fort que celui de la zone (15) de collecteur.

2. Procédé de fabrication d'un transistor bipolaire intégré,
- dans lequel on forme dans un substrat (21) semi-conducteur pour la séparation de transistors voisins des zones (23) d'oxyde d'isolement qui définissent une surface dégagée du substrat,
- dans lequel, après l'obtention des zones (23) d'oxyde d'isolement, on dépose sur toute la surface de la structure une couche (26a, 26b) conductrice dopée,
- dans lequel par diffusion de la couche (26a, 26b) conductrice, on produit dans un stade de traitement thermique dans le substrat une zone (24) de sous-collecteur qui est entourée des zones (23) d'oxyde d'isolement,
- dans lequel, on dépose sur toute la surface une couche d'isolement en une matière isolante,
- dans lequel, après une photolithographie on structure la couche (26a, 26b) conductrice et la couche d'isolement de façon à former dans la couche (26a, 26b) conductrice une couche (26) de borne de collecteur annulaire conductrice et dans la couche d'isolement une structure (27) d'isolement qui définit une zone active de transistor, de façon que la couche (26) de borne de collecteur et la structure (27) d'isolement soient disposées au bord de la zone (24) de sous-collecteur et comportent un flanc commun vertical déterminant la position de la zone (25) de collecteur,
et de façon que la couche (26) de borne de collecteur soit disposée au moins en partie sur les zones (23) d'oxyde d'isolement et soit reliée électriquement en contact direct avec la zone (24) de sous-collecteur,
- dans lequel on revêt les flancs déterminant la position de la zone (25) de collecteur d'un mince isolement (27a) de flanc en matière isolante,
- dans lequel on produit une zone (25) de collecteur par épitaxie sélective seulement au sein de la structure (27) d'isolement de sorte que la structure d'isolement de la zone (25) du collecteur soit isolée latéralement et que la zone (25) de collecteur ne soit reliée électriquement à la couche (26) de bome de collecteur que par la zone (24) de sous-collecteur, une nucléation sur la couche (26) de borne de collecteur enterrée pendant l'épitaxie sélective étant empêchée par l'isolement (27a) de flanc,
- dans lequel on donne à la zone (24) de sous-collecteur un dopage de même type de conductivité que celui de la zone (25) de collecteur mais plus fort que celui de la zone (25) de collecteur.

3. Procédé suivant la revendication 1 ou 2, **caractérisé par** les stades suivants :
a) on produit sur la zone (15, 25) de collecteur et la structure (17, 27) d'isolement qui l'entoure une borne (19, 29) annulaire de base,
b) on produit au sein de la borne (19, 29) annulaire de base sur la zone (15, 25) de collecteur une zone (18, 28) de base par épitaxie sélective.

4. Procédé suivant la revendication 3, **caractérisé en ce que** l'on produit la borne (19, 29) de base sur toute la surface par dépôt et ensuite par structuration.

5. Procédé de fabrication d'un circuit contenant des transistors bipolaires et des transistors CMOS ayant au moins un transistor bipolaire fabriqué suivant la revendication 1 ou 2, comportant les stades suivants :
a) après une implantation de canal et une production d'oxyde (56) de grille pour les transistors CMOS, on dépose sur toute la surface une couche (511) conductrice,
b) on structure la couche (56) conductrice de façon à y former les électrodes (Gp, Gn) de grille pour les transistors CMOS et la couche (59) enterrée de borne de collecteur pour le transistor bipolaire,
c) on finit de fabriquer les transistors CMOS à l'exception de l'obtention d'une métallisation,
d) on dépose sur toute la surface une couche (510) d'isolement dans laquelle on forme dans des stades opératoires ultérieurs la structure d'isolement du transistor bipolaire, et qui recouvre les transistors CMOS finis de traitement.
